**Europäisches Patentamt**

**European Patent Office**

**Office européen des brevets**

(19)

(11) Numéro de publication: **0 209 419 B1**

# FASCICULE DE BREVET EUROPEEN

(12)

(45) Date de publication du fascicule du brevet:
08.11.89

(51) Int. Cl.⁴: **H01L 21/28**, H01L 21/60

(21) Numéro de dépôt: **86401261.2**

(22) Date de dépôt: **10.06.86**

(54) Procédé de réalisation d'au moins deux métallisations d'un composant semiconducteur, recouvertes d'une couche de diélectrique, et composant obtenu par ce diélectrique.

(30) Priorité: **11.06.85 FR 8508808**

(43) Date de publication de la demande:
**21.01.87 Bulletin 87/4**

(45) Mention de la délivrance du brevet:
**08.11.89 Bulletin 89/45**

(84) Etats contractants désignés:
**DE GB NL**

(56) Documents cités:
**EP-A- 0 013 342**
**EP-A- 0 085 916**

**IEEE ELECTRON DEVICE LETTERS, vol. EDL-4, no. 4, avril 1983, pages 122-124, IEEE, New York, US; P.C. CHAO et al.: "0.2 Micron length T-shaped gate fabrication using angle evaporation"**
**PATENTS ABSTRACTS OF JAPAN, vol. 7, no. 247, 2 novembre 1983, page 128 E 208; & JP-A-58 135 679 (NIPPON DENSHIN DENWA KOSHA) 12-08-1983**

(73) Titulaire: **THOMSON-CSF, 51, Esplanade du Général de Gaulle, F-92800 Puteaux(FR)**

(72) Inventeur: **Pham Ngu, Tung, THOMSON-CSF SCPI 19, avenue de Messine, F-75008 Paris(FR)**
Inventeur: **Chevrier, Jean, THOMSON-CSF SCPI 19, avenue de Messine, F-75008 Paris(FR)**

(74) Mandataire: **Taboureau, James et al, THOMSON-CSF SCPI, F-92045 PARIS LA DEFENSE CEDEX 67(FR)**

## Description

La présente invention concerne un procédé de réalisation des métallisations auto-isolées sur un composant semiconducteur, tel qu'un transistor ou un circuit intégré, ce procédé permettant d'obtenir deux métallisations séparées par une distance, mesurée en surface de la pastille semiconductrice, inférieure à la définition des masques, c'est-à-dire inférieure à la plus petite dimension des masques. Le procédé selon l'invention s'applique à la réalisation de transistors, de circuits intégrés, de charges pour les transistors, ainsi qu'au croisement de pistes conductrices : en effet, les métallisations obtenues par ce procédé sont auto-isolées, c'est-à-dire recouvertes d'une couche isolante. L'invention concerne également les composants semiconducteurs produits au moyen de ce procédé.

Le développement de l'électronique rapide, c'est-à-dire celle qui est réalisée par exemple sur matériau III-V tel que GaAs ou les autres matériaux assimilés, se heurte à deux types de difficultés.

La première difficulté est liée à la limitation de la définition des masques. Bien que le masquage optique, c'est-à-dire obtenu par un faisceau de photons, soit dans bien des cas supplanté par le masquage électronique ou par rayons X qui permet de réaliser des traits distants de moins d'un micron, il serait souhaitable d'améliorer encore cette définition, ce qui permettrait notamment d'obtenir des transistors plus rapides, la distance source/drain dans les transistors à effet de champ étant diminuée, et donc le temps de transit des porteurs de charge diminué. Une telle amélioration serait intéressante dans la mesure où elle permettrait une application industrielle aboutissant à des rendements de fabrication normaux pour ce type d'activité, et dans la mesure où les problèmes de claquage entre deux métallisations sous tension de service seraient évités.

La seconde difficulté est spécifique aux transistors. Dans les circuits logiques intégrés ultra-rapides, il est très important de réduire les résistances d'accès parasites des transistors à effet de champ, c'est-à-dire les résistances entre source et grille et entre grille et drain. De nombreuses solutions ont été proposées. Les plus courantes sont : les transistors à canal creusé, et les transistors obtenus par implantation auto-alignée. Ces solutions ont donné de très bons résultats mais avec des rendements de fabrication très moyens à cause des difficultés de contrôle des tensions de seuil dans le creusement du canal ou dans le recuit des implantations.

Par contre, la technologie dite planar, c'est-à-dire celle dans laquelle la surface d'un composant semiconducteur est plane, présente le très grand avantage de bien controler cette tension de seuil. Avec la simplicité du procédé planar, le rendement de fabrication peut être très élevé. Mais le point faible de cette technologie est d'avoir des résistances d'accès parasites un peu plus élevées que dans les autres procédés décrits.

L'invention propose un nouveau procédé d'auto-isolement qui permet de réduire ces résistances parasites sans perdre l'avantage d'avoir des tensions de seuil bien contrôlées. En d'autres termes l'invention propose un procédé de réalisation d'au moins deux métallisations, qui sont auto-isolées, et dont la distance qui les sépare est plus faible que celle obtenue par les procédés connus jusqu'à présent.

Le procédé selon l'invention permet de réaliser au moins deux métallisations auto-isolées, dont la distance qui les sépare est plus petite que la plus faible dimension d'un motif de masquage par particules, électrons ou rayons X. Pour y parvenir, le procédé utilise la sous-gravure de la couche de résine qui constitue le masque, de sorte qu'un motif de résine ayant, sur sa surface libre, une dimension égale à la dimension minimale permise par la technologie employée, a sur sa surface en contact avec le substrat une dimension inférieure, parce que la couche de résine est sous-gravée. La sous-gravure est obtenue soit par rétro-diffusion de particules qui rebondissent sur le réseau cristallin du substrat, avec diffusion latérale dans la résine, soit par sous-gravure chimique, après avoir durci la surface libre de la couche de résine par un produit adéquat tel que le chloro-benzène par exemple. Les deux métallisations sont alors déposées de part et d'autre du motif de masquage, par un procédé directionnel, qui n'atteint pas l'espace en sous-gravure dans le masque, puis elles sont recouvertes d'une couche d'un isolant par un procédé non directionnel, de sorte que le matériau isolant remplit l'espace en sous-gravure. Le motif de masquage est ensuite supprimé par dissolution, selon la technique dite "lift off" : les deux métallisations auto-isolées sont séparées par une distance égale à la base du motif de masquage, c'est-à-dire une distance égale à la dimension minimale d'un motif diminué de deux fois la sous-gravure dudit motif. Si la technologie de masquage permet de réaliser des motifs de un micron par exemple, on sait les sous-graver de 0,25 micron, ce qui permet d'obtenir deux métallisations auto-isolées distantes de 0,5 micron : étant donné qu'elles sont recouvertes d'une couche d'isolant il suffit de remplir d'un métal l'intervalle entre les deux métallisations pour réaliser par exemple la grille d'un transistor à effet de champ dont la longueur est 0,5 micron, entre deux métallisations de source et de drain distantes de un micron.

De façon plus précise l'invention concerne un procédé de réalisation d'au moins deux métallisations d'un composant semiconducteur, recouvertes d'une couche de diélectrique, et séparées, en surface de la pastille du composant semiconducteur, par une distance inférieure à la définition de masque de fabrication dudit composant, ce procédé étant caractérisé en ce que la distance qui sépare les deux métallisations recouvertes de diélectrique est définie par sous-gravure d'un motif de résine du masque, ledit motif étant situé entre les deux métallisations recouvertes de diélectrique, et ayant sur sa face libre, une largeur égale à la définition du masque, et sur sa face en contact avec la pastille du composant une largeur égale à la définition du masque diminuée de deux fois la sous-gravure du motif.

L'invention sera mieux comprise par la description détaillée suivante de quelques exemples de réalisation, cette description s'appuyant sur les figures jointes en annexe qui représentent :

- figure 1 : vue en coupe d'un transistor selon l'art connu, définissant les dimensions critiques des ou entre les métallisations,
- figure 2 : vue en coupe d'un transistor obtenu par le procédé selon l'invention,
- figures 3 à 7 : différentes étapes du procédé de réalisation de deux métallisations auto-isolées selon l'invention,
- figure 8 : vue en coupe d'un circuit montrant trois exemples d'applications du procédé selon l'invention.

Bien que le procédé s'applique d'une façon générale à la réalisation de métallisations dont deux au moins sont séparées entre elles par une dimension inférieure aux dimensions minimales du masque de réalisation, l'invention sera exposée en s'appuyant sur le cas de la réalisation d'un transistor à effet de champ, de façon à être plus précise dans sa description. Toutefois il est bien entendu que ce cas ne concerne qu'un exemple de l'application du procédé, qui est d'ailleurs illustré par la réalisation d'autres composants qu'un transistor à effet de champ, sans pour autant apporter une limitation au domaine de l'invention.

La comparaison préalable entre un transistor à effet de champ obtenu par un procédé de l'art connu et un transistor à effet de champ obtenu par le procédé selon l'invention permettra de mieux faire comprendre le sens et l'intérêt du procédé qui sera décrit par la suite.

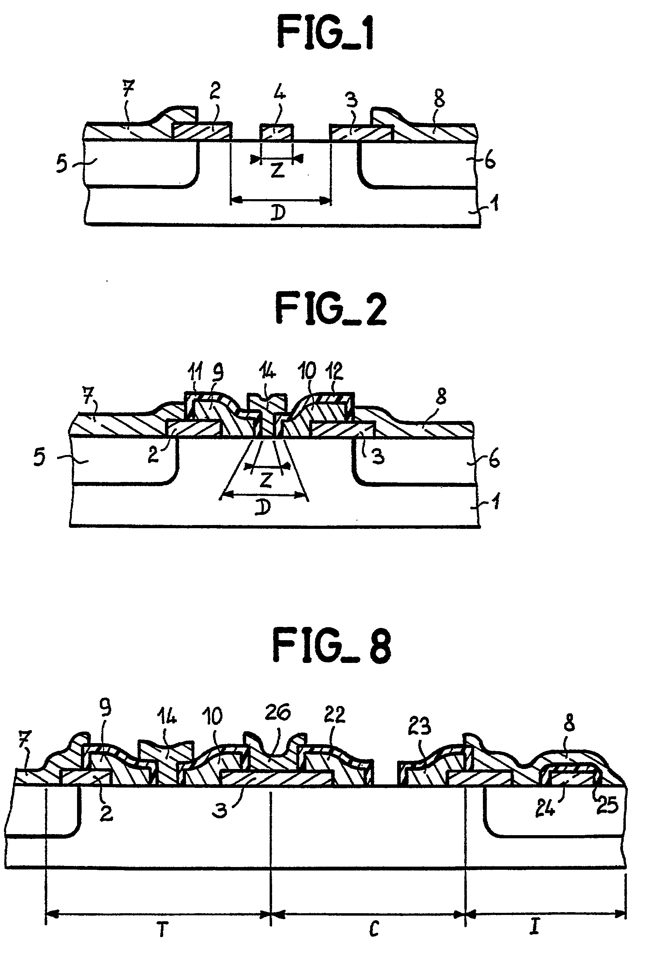

La figure 1 représente de façon très schématique la vue en coupe d'un transistor selon l'art connu. Un tel transistor est réalisé sur un substrat 1, dont une face supporte des métallisations d'accès 2 et 3, par exemple la source et le drain, et une métallisation de contrôle 4 qui est la grille. Des caissons implantés, par exemple avec du bore, dans le substrat 1 permettent de délimiter la couche active du transistor, qui est comprise entre ces caissons 5 et 6, et sous la région couverte par les métallisations 2, 3 et 4. Des métallisations 7 et 8, prenant des contacts ohmiques sur les métallisations d'accès ou de controle permettent de réunir ce transistor au reste du circuit électronique.

Pour pouvoir travailler dans des fréquences très élevées, correspondant à l'électronique ultra-rapide telle que celle qui est actuellement développée sur des matériaux de la famille III-V, il faut pouvoir d'une part réaliser une grille de longueur Z très petite, et d'autre part déposer des métallisations de source 2 et de drain 3 avec un écartement ou une distance D qui les sépare la plus petite possible. En effet ces dimensions Z pour la grille et D pour la source et le drain permettent de controler le temps de transit des électrons dans la couche active et plus ces dimensions sont petites plus ce temps de transit est faible, plus la fréquence de travail du transistor est élevée. En outre les résistances d'accès entre la source 2 et la grille 4 et entre le drain 3 et la grille 4, correspondant aux distances parcourues par les électrons dans la couche active du transistor sont d'autant plus faibles que les électrodes de source 2 et de drain 3 sont plus proches de la grille 4. Mais par contre, la proximité entre les métallisations est limitée par le risque de claquage lorsque le transistor est en service et que des différences de tension existent entre ces différentes métallisations. A titre d'exemple, dans les transistors actuels la longueur Z de grille est de l'ordre ou supérieure à 0,7 micron, et la distance D entre source et drain est classiquement de l'ordre de trois microns, ce qui fait environ 1,1 microns entre les métallisations 2 et 4 de source et de grille et 1,1 microns entre les métallisation 3 et 4 de drain et de grille.

La figure 2 représente une vue en coupe d'un transistor dont les métallisations ont été obtenues par le procédé selon l'invention. Celui-ci comporte un substrat 1, dans lequel ont été implantés des caissons 5 et 6, et sur lequel des conducteurs électriques 7 et 8 sont en contact ohmique avec des métallisations primaires de source et de drain 2 et 3. Ces métallisations sont dites primaires car elles sont nécessaires pour assurer le contact ohmique entre les vraies métallisations de source et de drain 9 et 10 et les interconnexions externes 7 et 8.

A partir de ce transistor semi-ébauché par des techniques classiques, les métallisations de source 9 et de drain 10 sont déposées par le procédé de l'invention qui sera décrit ultérieurement : le point original est que ces deux métallisations 9 et 10 sont distantes entre elles d'une dimension D inférieure à la limite de masquage conventionnel, avec la technologie courante, et que en outre chacune de ces deux métallisations est recouverte d'une couche d'isolant, 11 sur la métallisation 9 et 12 sur la métallisation 10. La distance Z qui sépare les couches d'isolants qui recouvrent les métallisations 9 et 10 permet de réaliser dans cet intervalle une métallisation 14 de grille. A titre de comparaison avec le transistor selon l'art connu décrit en figure 1, pour un transistor réalisé selon le procédé de l'invention, la longueur Z de la grille 14 est égale à 0,5 micron et la distance D qui sépare les métallisations 9 et 10 de source et de drain est égale à 1 micron.

Le fait que les métallisations de source et de drain 9 et 10 soient réalisées de façon auto-isolée, c'est-à-dire que la couche isolante 11 et 12 qui les recouvre vient au cours de la même opération de fabrication, avec le même masque, permet de rapprocher lesdites métallisations de source et de drain à une distance que ne permet pas la techologie classique car il y aurait alors claquage en raison d'une trop courte longueur entre les métallisations, lorsqu'elles sont sous tension. De même cette couche d'isolement 11 et 12 permet de réaliser une grille qui s'appuie directement sur les métallisations de source et de drain, sans pour autant être en court circuit avec elles puisqu'elle en est séparée par une couche d'isolement.

Bien entendu la nature même du transistor à effet de champ c'est-à-dire son fonctionnement en déplétion ou en enrichissement, et sa structure sous les métallisations, n'a aucun lien avec l'invention. Cette structure peut être à hétérojonctions ou à homojonctions ; ce qui est important est de réaliser une grille très fine disposée entre deux électrodes de source et de drain très rapprochées entre elles.

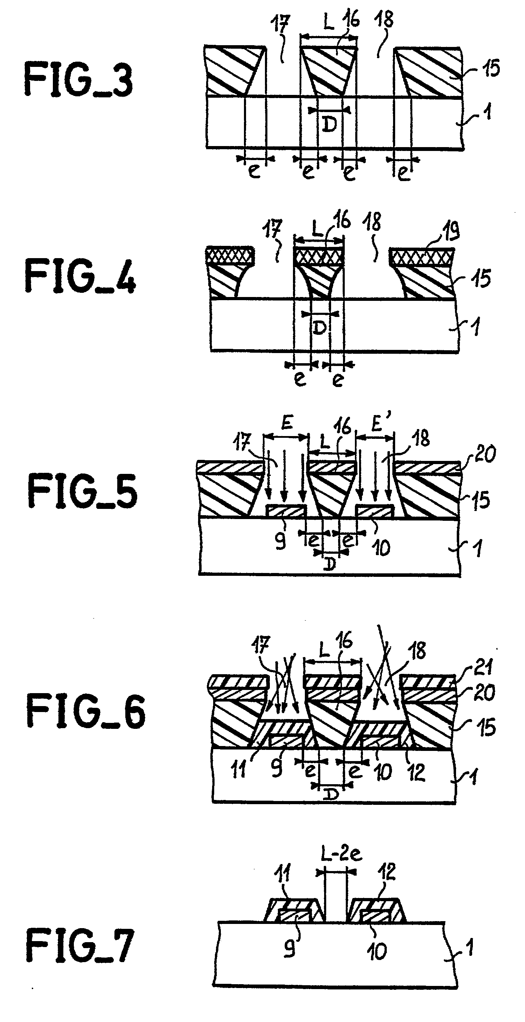

Les figures 3 à 7 représentent les différentes étapes de réalisation de deux métallisations auto-isolées selon l'invention.

En figure 3, une couche de résine de masquage 15 est déposée sur un substrat 1, qui est par exemple la rondelle dans laquelle sont fabriqués des transistors ou des circuits intégrés. Dans la couche 15 de résine de masquage est défini au moins un motif 16, au moyen de deux ouvertures 17 et 18. Le motif 16 peut être défini par un masquage optique, c'est-à-dire utilisant des photons pour déterminer un dessin dans le masque, mais bien entendu le masquage électronique ou par rayons X est préférable puisque l'on cherche à réaliser des motifs dont les dimensions sont plus petites que les dimensions que l'on sait obtenir avec les technologies actuelles de masquage. Le motif 16 a donc sur sa surface libre, c'est-à-dire la surface extérieure, une dimension minimale L qui est par exemple 1 micron. On peut obtenir pour ce motif 16 une base, c'est-à-dire sa surface en contact avec le substrat 1, dont les dimensions "D" sont plus petites que les dimensions L de la surface libre. Pour cela le masque de résine 15 est développé soit avec une sur-exposition lumineuse, soit avec un surdosage électronique de telle sorte que la résine est attaquée, dans sa partie inférieure située du côté du substrat 1, et ainsi sous-gravée. Dans le cas du développement par un faisceau électronique, il est connu que les électrons rebondissent sur le réseau cristallin du matériau semiconducteur constituant le substrat 1, et que ce rebondissement donne lieu à une rétrodiffusion qui sous-grave le motif 16 sur une largeur "e" de chaque côté du motif, de telle sorte que la base du motif 16 a une largeur "D" égale à la largeur L de sa partie libre, diminué de deux fois la sous-gravure "e".

La figure 4 représente une variante de la réalisation du motif 16, cette variante étant obtenue en masquage optique. Dans ce cas on peut obtenir une sous-gravure du masque 15 en durcissant la couche 19 de sa surface libre par un produit adéquat tel que par exemple le chloro-benzène. La surface 19 étant ainsi durcie, lorsque la résine est dissoute par un solvant chimique, cette action du solvant a un effet latéral plus important du côté du substrat que du côté de la surface libre 19 puisque celle-ci a été durcie ; il en résulte donc également une sous-gravure du motif 16 qui donne lieu à un rétrécissement de sa base égal à deux fois la sous-gravure "e".

L'opération suivante est représentée en figure 5. Elle consiste à opérer un dépôt métallique par évaporation du métal adéquat avec un canon électronique, dont le flux d'ions est directionnel. Dans un canon électronique le métal d'apport est chauffé ponctuellement par un faisceau électronique : le rayon d'ions métalliques émis par le métal ainsi chauffé est de section très petite et parallèle à lui-même. Le dépôt directionnel est représenté sur la figure 5 par des flèches parallèles entre elles, qui pénètrent par les ouvertures 17 et 18 pour déposer dans le fond des dites ouvertures de part et d'autre du motif 16 les deux métallisations 9 et 10. Ces métallisations ont donc des dimensions qui correspondent aux dimensions E et E' des ouvertures 17 et 18. Par conséquent puisque la couche de résine de masquage 15 a été sous-gravée, les métallisations 9 et 10 n'entrent pas en contact avec les parois de la couche de résine 15 dans la région de sous-gravure. Simultanément une couche de métal 20 est déposée sur la surface libre du masque 15.

Le fait que les métallisations 9 et 10 n'entrent pas en contact avec les parois sous-gravées du masque de résine 15 est mis à profit dans l'opération suivante représentée en figure 6. Un isolant tel que de la silice $SiO_2$, du nitrure de silicium $Si3N4$, ou même un polymère isolant est déposé dans le fond des ouvertures 17 et 18 par une pulvérisation non directionnelle. Cette pulvérisation non directionnelle, également appelée sputtering, est symbolisée par des flèches non parallèles entre elles. Le dépôt d'isolant remplit par conséquent, au moins jusqu'à une certaine hauteur, les ouvertures 17 et 18 qui délimitent le motif 16. Donc l'isolant recouvre complètement les métallisations 9 et 10, donnant ainsi les deux couches 11 et 12 représentées en figure 2. Bien entendu une couche d'isolant 21 est également déposée en surface du masque de résine 15.

On peut remarquer que puisque le métal 9 et 10 a été déposé à l'étape précédente selon le contour des ouvertures 17 et 18, c'est-à-dire avec un espacement "e" par rapport à la base sous-gravée du motif 16 du masque de résine 15, il s'ensuit que, en figure 6, ces mêmes métallisations 9 et 10 sont isolées, dans un plan horizontal par une épaisseur "e" de l'isolant, silice ou nitrure de silicium.

La figure 7 représente la dernière étape du procédé de réalisation de deux métallisations auto-isolées : par une opération de lift-off, on enlève le masque de résine 15, ainsi que les dépôts de métal 20 et d'isolant 21 déposés sur sa surface libre. Il ne reste donc que les métallisations 9 et 10, recouvertes par une couche d'isolant 11 et 12, qui n'ont pas été dissoutes par le solvant de la résine de masquage. Ces métallisations 9 et 10, auto-isolées par les couches 11 et 12, sont donc distantes entre elles d'une dimension égale à L-2e, cette dimension étant plus petite que la définition du masque 15 puisque celle-ci est égale à L, hypothèse de départ, puisqu'on ne sait pas réaliser de motif dont les dimensions soient inférieures à L, dans une technologie de masquage donné.

Les figures 3 à 7 ont décrit le procédé de réalisation de deux métallisations 9 et 10 directement déposées sur un substrat 1. Bien entendu s'il s'agit de réaliser un transistor tel que celui de la figure 2, dans laquelle les métallisations de source et de drain 2 et 3 sont rapprochées par l'apport de nouvelles métallisations de source et de drain 9 et 10, le procédé décrit dans les figures 3 à 7 doit faire porter une partie des métallisations 9 et 10, c'est-à-dire également les motifs de masquage, partiellement sur les métallisations pré-existantes 2 et 3. Celles-ci sont en fait nécessaires puisque les métallisations réalisées avec le procédé de l'invention sont automatiquement recouvertes d'un isolant : par conséquent s'il n'y a pas précédemment de dépôt de métal ohmique 2 et 3, il ne sera pas possible d'assurer la continuité électrique entre les métallisations de source et de drain 9 et 10 et les métallisations d'accès extérieur 7 et 8.

La figure 8 représente la vue en coupe d'un circuit dans lequel sont intégrés trois exemples d'application du procédé selon l'invention. Ce circuit, symbolique, comporte un transistor dans la région repérée T, une charge active dans la région repérée C et un croisement d'interconnexion dans la région repérée I.

Le transistor de la région repérée T est celui qui est représenté en figure 2 et il comporte deux électrodes 9 et 10 de source et de drain et une électrode de grille 14. La charge active, dans la région repérée C, est un transistor sans grille. On sait que dans les circuits logiques, notamment rapides, les résistances sont souvent remplacées par des transistors dont la grille est supprimée. Par conséquent la charge d'un transistor tel que celui qui est à gauche de la figure peut très bien être réalisée, au cours des mêmes opérations et avec la même technologie de fabrication, par une charge active constituée uniquement par deux métallisations 22 et 23 auto-isolées. Le courant passe dans l'épaisseur de la couche active du circuit entre les deux électrodes 22 et 23, avec une intensité qui dépend exclusivement de la tension délivrée par le transistor. Enfin puisque le procédé selon l'invention fournit des métallisations qui sont auto-isolées, ce procédé peut être utilisé pour assurer des croisements entre deux conducteurs, sans court-circuit puisque le conducteur tel que représenté par la métallisation 24 est isolé du conducteur 8 par la couche d'isolant 25 qui le recouvre.

On voit donc que pour réaliser un circuit intégré comportant simultanément au moins un transistor, une charge active et un croisement entre conducteurs, les opérations peuvent être menées simultanément. Il suffira, au cours de la dernière métallisation qui va fournir la grille 14 du transistor et les métallisations d'interconnexions 7, 8 et 26 de masquer convenablement les parties qui ne doivent pas être métallisées, telles que par exemple, l'emplacement de la grille, supprimée, dans la charge active, ainsi que les espaces recouvrants les métallisations 9, 10, 22 et 23 pour éviter que le dernier dépôt métallique ne court-circuite les métallisations actives dans ce circuit.

Le tableau suivant donne les dimensions du masque et des dépôts métalliques auto-isolés qu'on peut obtenir avec la technique du procédé selon l'invention. Ces dimensions sont données en microns, et la colonne repérée T concerne la réalisation d'un transistor tandis que la colonne repérée I concerne la réalisation de croisements entre des conducteurs tels que les conducteurs 24 et 8.

| | | T | I |
|---|---|---|---|
| Epaisseur du masque de résine | 15 | 1 | 1 |
| Ouvertures | E | 2 | 2 |
| Distance entre deux ouvertures | L | 1 | 2 |
| Largeur à la base d'une ouverture | | 2,5 | 2,5 |
| Largeur à la base d'un motif | D | 0,5 | 1,5 |
| Epaisseur de métal | 20 | 0,15 | 0,15 |
| Epaisseur de diélectrique | 21 | 0,2 | 0,2 |

Bien que le procédé selon l'invention concerne essentiellement la réalisation de deux métallisations sur un substrat, ces métallisations étant d'avantage rapprochées l'une de l'autre que ne le permet la technologie actuelle de masquage, ce procédé est surtout intéressant pour réaliser des transistors auto-isolés. Il s'agit d'une technique planar puisqu'il n'y a pas au cours des différentes opérations de creusement dans la plaquette de matériaux semiconducteurs de départ. A cette technique planar et au procédé de réalisation des métallisations auto-isolées sont liés un certain nombre d'avantages relatifs au fonctionnement du transistor. Ce sont :
- une faible tension de déchet grâce au rapprochement des contacts de source et drain,
- de faibles résistances d'accès puisque la distance entre les électrodes de source et de drain et l'électrode de grille n'est plus égale qu'à l'épaisseur du diélectrique déposé sur les deux métallisations de source et drain,
- une meilleure transconductance,
- une meilleure résistance au claquage grâce à la présence de diélectriques intercalés entre les trois métallisations de source, de grille et de drain,
- une excellente tolérance d'alignement de la grille par rapport au contact de source et drain, puisqu'on utilise les métallisations de source et de drain comme masque pour la fabrication de la métallisation de grille autoalignée,
- possibilité de réaliser des grilles de 0,5 micron de longueur.

En raison du risque de claquage, il est inutile dans les transistors classiques de réaliser des grilles de 0,5 micron de longueur, car la résistance parasite liée à la distance entre grille et électrode de source ou de drain atténue l'effet de réduction de la longueur de grille : cela devient possible avec le procédé selon l'invention, et la présence de la couche d'isolant élimine le risque de claquage.

Le procédé de réalisation de métallisations auto-isolées est essentiellement utilisé pour la fabrication de composants discrets ou intégrés en électronique ultra-rapide, notamment pour les circuits logiques sur GaAs ou matériaux III-V, destinés aux télécommunications, aux radars, aux faisceaux hertziens.

## Revendications

1. Procédé de réalisation d'au moins deux métallisations comportant étapes suivantes :

a) réalisation sur un substrat (1) d'un masque de résine (15), comportant au moins un motif (16), compris entre deux ouvertures (17, 18), la dimension (L) entre les deux ouvertures (17, 18) étant égale à la plus faible dimension réalisable du masque (définition du masque),

b) sous-gravure (e) de la résine (15), communiquant au motif (16) une dimension (D) à la base inférieure à sa dimension (L) sur sa surface libre, entre les deux ouvertures (17, 18),

c) dépôt d'une couche de métal par un procédé directionnel pour former au moins deux métallisations (9, 10), sur le substrat (1), lesdites métallisations (9, 10) ayant les mêmes dimensions que celles (E, E') des ouvertures (17, 18),

d) dépôt sur les métallisations (9, 10) d'une couche d'un matériau diélectrique isolant (11, 12) par un procédé non directionnel, ladite couche de diélectrique remplissant l'espace sous-gravé (e) entre le motif de résine (16) et les métallisations (9, 10),

e) élimination du masque de résine (15) et du motif (16) par dissolution, laissant sur le substrat (1) deux métallisations (9, 10) auto-isolées (11, 12) séparées par une distance D=L-2e inférieure à la définition (L) du masque.

2. Procédé selon la revendication 1, caractérisé en ce que, si le masquage électronique est utilisé, la sous-gravure (e) de la résine du masque (15) est obtenue par un surdosage des électrons.

3. Procédé selon la revendication 1, caractérisé en ce que, si le masquage optique est utilisé, la sous-gravure (e) de la résine du masque (15) est obtenue par une surexposition lumineuse, avec durcissement de la couche superficielle du masque par le chlorobenzène.

4. Procédé selon la revendication 1, caractérisé en ce que les métallisations (9, 10) sont déposées par évaporation directionnelle.

5. Procédé selon la revendication 1, caractérisé en ce que le matériau diélectrique (11, 12) déposé sur les métallisations (9, 10) est déposé par pulvérisation sous plasma.

6. Procédé selon la revendication 1, caractérisé en ce que le matériau diélectrique déposé sur les métallisations (9, 10) est de l'oxyde ou du nitrure de silicium.

7. Procédé selon la revendication 1, caractérisé en ce que le matériau diélectrique déposé sur les métallisations (9, 10) est une résine polymérisable, non soluble dans le solvant d'élimination du masque (15).

8. Dispositif semiconducteur de type transistor, caractérisé en ce qu'il comprend, supportées par la surface de sa pastille (1), deux métallisations (2, 3) d'électrodes d'accès et, en contact ohmique avec celles-ci (2, 3) et les recouvrant partiellement, au moins deux métallisations (9, 10) auto-isolées (11, 12), l'espace entre ces dites métallisations (9, 10) étant rempli par une métallisation (14) d'électrode de contrôle, qui prend appui sur les couches isolantes (11, 12) des métallisations d'électrodes d'accès.

9. Dispositif semiconducteur selon la revendication 9, caractérisé en ce que les métallisations (9, 10) auto-isolées (11, 12) sont réalisées selon le procédé de la revendication 1.

## Claims

1. A method for the production of at least two metallized coatings comprising the following steps:

(a) the production, on a substrate (1), of resin mask having at least one design (16), comprised between two openings (17 and 18), the dimension (L) between the two openings (17 and 18) being equal to the smallest dimension able to be produced on the mask (definition of the mask),

(b) undercut etching (e) of the resin (15) imparting to the design (16) a dimension (D) at the base less that its dimension (L) on the free surface, between the two openings (17 and 18),

(c) the deposit of a layer of metal by a directional process to form at least two metallized coatings (9 and 10) on the substrate (1), said metallized coatings (9 and 10) having the same dimensions as those (E and E') of the openings (17 and 18),

(d) the deposit on the metallized layers (9 and 10) of an insulating dielectric material (11 and 12) by a non-directional process, said layer of dielectric filling the undercut-etched space (3) between the resin design (16) and the metallized layers (9 and 10), and

(e) elimination of the resin mask (15) and of the design (16) by dissolving them, while leaving two mutually insulating (11 and 12) metallized coatings (9 and 10) on the substrate (1) separated by a distance D equal to L−2e less than the definition (L) of the mask.

2. The method as claimed in claim 1, characterized in that if electronic masking is used, the undercut etching (e) of the resin of the mask (15) is obtained by an overly high electron dose rate.

3. The method as claimed in claim 1, characterized in that if optical masking is used, the undercut etching (e) of the resin of the mask (15) is performed by overexposure to light, the superficial layer of the mask being hardened by chlorobenzene.

4. The method as claimed in claim 1, characterized in that the metallized layers (9 and 10) are deposited by directional evaporation.

5. The method as claimed in claim 1, characterized in that the dielectric materials (11 and 12) deposited on the metallized coatings (9 and 10) are deposited by plasma sputtering.

6. The method as claimed in claim 1, characterized in that the dielectric material deposited on the metallized coatings (9 and 10) is silicon oxide or nitride.

7. The method as claimed in claim 1, characterized in that the dielectric material deposited on the metallized coatings (9 and 10) is a polymerizable resin which is not soluble in the solvent used for the elimination of the mask (15).

8. A transistor-type semiconductor device, characterized in that it comprises, supported on the surface of its chip (1), two access electrode metallized coatings (2 and 3) and, in ohmic contact with the same (2 and 3) so as to partially cover them, at least two mutually insulated (11 and 12) metallized coatings (9 and 10), the clearance between the two metallized coatings (9 and 10) being filled by a control electrode metallization (14) which is supported on the insulating coatings (11 and 12) of the access electrode metallized coatings.

9. The device as claimed in claim 9, characterized in that the mutually insulated (11 and 12) metallized coatings (9 and 10) are produced in accordance with claim 1.

## Patentansprüche

1. Verfahren zur Durchführung von mindestens zwei Metallisierungen, die folgenden Stufen umfassend:

a) Bildung einer Harzmaske (15) auf einem Substrat (1) mit mindestens einem Motiv (16), das zwischen zwei Öffnungen (17, 18) liegt, wobei die Abmessung (L) zwischen den beiden Öffnungen (17, 18) der schwächsten durchführbaren Abmessung der Maske entspricht (Auflösung der Maske), b) Subgravierung (e) des Harzes (15), die dem Motiv (16) eine Abmessung an der Basis (D) gibt, die niedriger als seine Abmessung (L) auf seiner freien Fläche zwischen den beiden Öffnungen (17, 18) ist,

c) Auftragung einer Metallschicht durch ein gerichtetes Verfahren, um mindestens zwei Metallisierungen (9, 10) auf dem Substrat (1) zu bilden, wobei besagte Metallisierungen (9, 10) dieselben Abmessungen wie diejenigen (E, E') der Öffnungen (17, 18) haben,

d) Auf den Metallisierungen (9, 10) erfolgendes Auftragen einer Schicht eines isolierenden Dielektrikums (11, 12) durch ein ungerichtetes Verfahren, wobei besagte dielektrische Schicht den subgravierten Raum (e) zwischen dem Harzmotiv (16) und den Metallisierungen (9, 10) ausfüllt, e) Beseitigung der Harzmaske (15) und des Motivs (16) durch Auflösung, wobei auf dem Substrat (1) zwei selbstisolierte (11, 12) Metallisierungen (9, 10) zurückgelassen werden, die durch eine Distanz D=L−2e getrennt sind, die niedriger als die Auflösung (L) der Maske ist.

2. Verfahren nach Anspruch 1, dadurch gekennzeichnet, daß bei Verwendung elektronischer Maskierung die Subgravierung (e) des Harzes der Maske (15) durch eine Elektronen-Überdosierung erzielt wird.

3. Verfahren nach Anspruch 1, dadurch gekennzeichnet, daß bei Verwendung optischer Maskierung die Subgravierung (e) des Harzes der Maske (15) durch eine Überbelichtung erzielt wird, mit Erhärtung der Oberflächenschicht der Maske durch Chlorbenzol.

4. Verfahren nach Anspruch 1, dadurch gekennzeichnet, daß die Metallisierungen (9, 10) durch gerichtete Aufdampfung erfolgen.

5. Verfahren nach Anspruch 1, dadurch gekennzeichnet, daß das auf den Metallisierungen (9, 10) aufgebrachte Dielektrikum (11, 12) durch Plasmazerstäubung aufgebracht wird.

6. Verfahren nach Anspruch 1, dadurch gekennzeichnet, daß das auf den Metallisierungen (9, 10) aufgebrachte Dielektrikum Siliziumoxid oder Siliziumnitrid ist.

7. Verfahren nach Anspruch 1, dadurch gekennzeichnet, daß das auf den Metallisierungen (9, 10) aufgebrachte Dielektrikum ein polymerisierbares Harz ist, das im Lösungsmittel für die Beseitigung der Maske (15) nicht löslich ist.

8. Halbleiterbauelement vom Typ Transistor, dadurch gekennzeichnet, daß er zwei von der Oberfläche seiner Pastille (1) getragene Eingangselektroden-Metallisierungen (2, 3) umfaßt und − in Ohmschem Kontakt mit diesen (2, 3) und sie teilweise bedeckend − mindestens zwei selbstisolierte (11, 12) Metallisierungen (9, 10), wobei der Raum zwischen besagten Metallisierungen (9, 10) durch eine Steuerelektroden-Metallisierung (14) ausgefüllt ist, die auf den Isolierschichten (11, 12) der Eingangselektroden-Metallisierungen aufliegt.

9. Halbleiterbauelement nach Anspruch 8, dadurch gekennzeichnet, daß die selbstisolierten (11, 12) Metallisierungen (9, 10) nach dem Verfahren des Anspruchs 1 durchgeführt werden.

# FIG_1

# FIG_2

# FIG_8

FIG_3

FIG_4

FIG_5

FIG_6

FIG_7